# EUROPEAN PATENT APPLICATION

(11) **EP 2 500 936 A1**
(43) Date of publication of application: **19.09.2012**
(21) Application number: 09851241.1
(22) Date of filing: 13.11.2009
(51) Int. Cl.: H01L 23/36, C23C 24/04, H01L 25/07, H01L 25/18

(54) **INSULATING STRUCTURE AND METHOD FOR MANUFACTURING SAME**

(71) Applicant: Hitachi, Ltd., Chiyoda-ku Tokyo 100-8280 (JP)
(72) Inventor: SATO, Keishi, Yokohama-shi Kanagawa 244-0817 (JP); ISHIHARA, Shosaku, Yokohama-shi Kanagawa 244-0817 (JP)
(74) Representative: Calderbank, Thomas Roger
(86) International application number: PCT/JP2009/006063
(87) International publication number: WO 2011/058607

(57) **Abstract**

To provide an insulating heat conductive structure with high thermal conductivity and stability to a thermal deformation action caused by temperature cycles and the like.

The present invention includes an insulating layer, a circuit layer on at least a part of a surface of the metal base material in this order from the metal base material side in the manufacturing process of the insulating heat conductive structure. The insulating layer is formed of a composite phase including ceramic phases and resin phases. In an insulating layer cross-sectional surface, the ceramic phases, which are formed of a number of deposited ceramic particles, are formed in a plurality of independent patterns where the ceramic phases has a portion buried in the metal base material and the circuit layer. The resin phases is impregnated in voids between the ceramic phases.

## Description

### Technical Field

The present invention relates to an insulating heat conductive structure and a method for manufacturing the insulating heat conductive structure.

### Background Art

In semiconductor modules of recent years, especially in a power semiconductor module that controls high current switching, a semiconductor devices has been increasing in heat generation amount with the rapid progress of the semiconductor device in high output power and high integration. This requires for the semiconductor device to have improved cooling efficiency. An insulating substrate that has high thermal conductivity and stability to a thermal deformation action caused by temperature cycles and the like is under study. For example, Japanese Patent Application Laid-Open Publication No. 2006-278558 (PLT 1) discloses an insulating heat conductive structure with a ceramic layer that is directly formed on a metal base material by an aerosol deposition method. PLT 1 also discloses a power semiconductor module including the insulating heat conductive structure.

### Citation List

### Patent Literature

PLT1: Japanese Patent Application Laid-Open Publication No. 2006-278558

### Summary of Invention

### Technical Problem

However, as a problem of a conventional insulating heat conductive structure, achieving both of high thermal conductivity and stability to a thermal deformation action is still unsolved. That is, assume that temperature cycles and the like cause thermal deformation on a ceramic layer, which constitutes an insulating layer, a metal base material, and a circuit layer. This generates thermal stresses associated with thermal expansion differences between the ceramic layer and the metal base material and between the ceramic layer and the circuit layer, thus posing a risk of crack formation in the ceramic layer. In contrast, assume that a plurality of ceramic layers with different thermal expansion coefficients are laminated to reduce thermal stresses on boundary faces between the ceramic layer and the metal base material and between the ceramic layer and the circuit layer. The insulating layer increases in thermal resistance with increasing film thickness of the insulating layer. This decreases thermal conductivity of the insulating heat conductive structure.

The present invention has been made in view of the above-described circumstances, and it is an object of the present invention to provide an insulating heat conductive structure with high thermal conductivity and stability to a thermal deformation action caused by temperature cycles and the like.

### Solution to Problem

To achieve the above-described object, the inventors have perceived the following insulating heat conductive structures and methods for manufacturing the insulating heat conductive structure from various kinds of study results.

The present invention provides the insulating heat conductive structure that includes a metal base material, an insulating layer formed on the metal base material, and a metal layer formed on the insulating layer in the manufacturing process of the insulating heat conductive structure. The insulating layer includes a ceramic phase and a resin phase.

The present invention includes forming ceramic phases on a metal base material by particle impaction deposition, forming resin phases between the ceramic phases, and forming a metal layer on the ceramic phases and the resin phases.

### Advantageous Effects of Invention

The present invention provides a low-cost insulating heat conductive structure with high thermal conductivity and stability to a thermal deformation action caused by temperature cycles and the like.

### Brief Description of Drawings

[FIGs. 1] FIGs. 1 are schematic cross-sectional views of an insulating heat conductor according to a first embodiment of the present invention.
[FIG. 2]FIG. 2 is a cross-sectional view of the insulating heat conductor taken along the line X-X shown in FIG. 1.
[FIGs. 3]FIGs. 3 are schematic diagrams illustrating a manufacturing process of the insulating heat conductor according to the first embodiment of the present invention.
[FIG. 4]FIG. 4 is a schematic cross-sectional view of an insulating heat conductor according to a second embodiment of the present invention.
[FIGs. 5]FIGs. 5 are schematic diagrams illustrating a manufacturing process of the insulating heat conductor according to the second embodiment of the present invention.

### Description of Embodiments

Embodiments of the present invention will be described below by referring to the accompanying drawings.

### First Embodiment

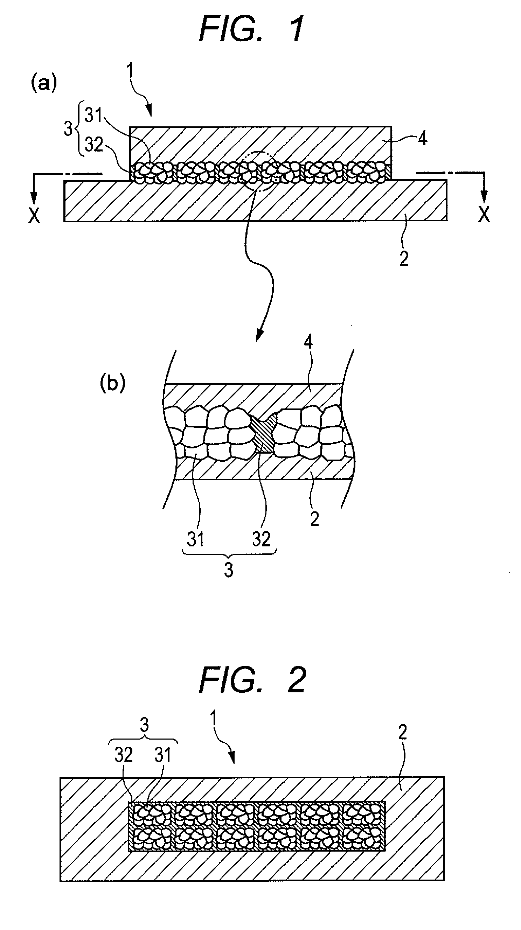

A first embodiment of the present invention and its manufacturing method will be described in detail below by referring to FIG. 1 to FIG. 3. In the following embodiment, an exemplary configuration of an insulating heat conductor used in a power semiconductor module will be described. The use of the insulating heat conductor is not limited to the following embodiment.

As shown in FIG. 1, the insulating high heat conductive structure 1 according to this embodiment includes, for example, an insulating layer 3 and a circuit layer 4 on at least a part of a surface of a plate-shaped metal base material 2, which is made of Al or Al alloy, in this order from the metal base material side.

The metal base material 2 may employ a conductive material with high coefficient of thermal conductivity such as Cu, Cu alloy, Al, and Al alloy.

The metal base material 2 has no restrictions on its shape and thickness. Various kinds of shapes and thicknesses such as a plate shape, a foil shape, and a comb shape may be selected according to the type of usage of the insulating heat conductor 1.

As shown in FIG. 1 and FIG. 2, the insulating layer 3 is formed of a composite phase including ceramic phases 31 and resin phases 32. In an insulating layer 3 cross-sectional surface, the ceramic phases 31, which are each formed of a number of deposited ceramic particles, are formed in a plurality of independent patterns. The ceramic phase 31 is partially buried in the metal base material 2 and the circuit layer 4. In the insulating layer 3 cross-sectional surface, the insulating layer 3 includes the resin phases 32 impregnated in voids between the ceramic phases 31.

The ceramic phase 31 may employ an insulating material with high coefficient of thermal conductivity such as aluminum oxide, silicon oxide, aluminum nitride, silicon nitride, boron nitride, diamond, and silicon carbide.

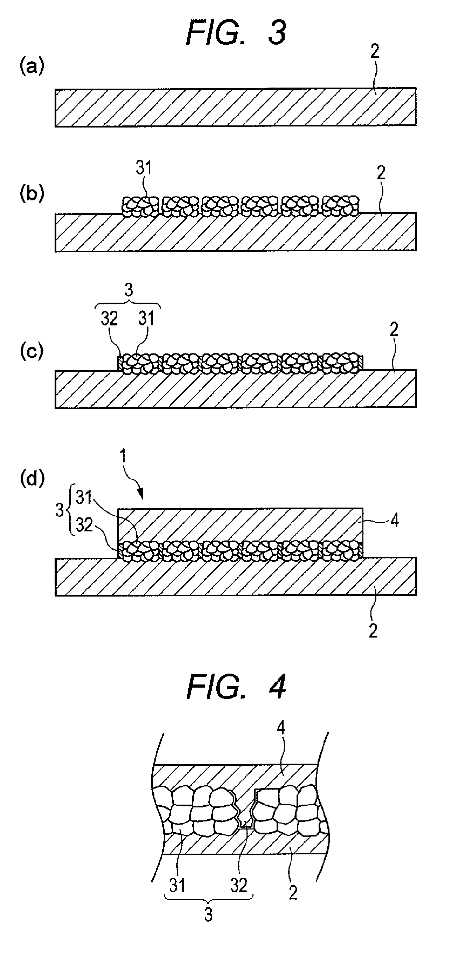

It is preferred that a method for forming the ceramic phase 31 forms the ceramic phases 31 on the surface of the metal base material 2 shown in FIG. 3(a) such that the ceramic phases have a portion buried in the metal base material 2 as shown in FIG. 3(b). For example, it is preferred to use an aerosol deposition method that uses ceramic particles as raw material, and particle impaction deposition, which is typified by a cold spray method. As an example, the aerosol deposition method is a film forming method that sprays ceramic fine powder in a solid state on a substrate at ordinary temperature with only mechanical impact force and without heating. This film forming method forms a ceramic coating that has high density and high transparency, high strength, and high adhesive power. The cold spray method is a film forming method that produces a flow of material powder at high temperature and high speed to spray the material power on an object surface, thus performing deposition and coating.

When forming the ceramic phases 31 in a plurality of independent patterns having grooves between the patterns, the following method is preferred to be used. The method preliminarily arranges a mask pattern over portions on the surface of the metal base material 2 where the grooves are to be formed, and then bombards ceramic particles by the above-described film forming method. After forming the film, the mask pattern is removed before formation of the resin phases 32.

Any material may be used for the resin phase 32 insofar as the resin phases 32 satisfies required voltage resistance and stress relaxation function. For example, epoxide-based resin and polyimide-based resin may be used. Different phase material such as inorganic filler may be added.

Any method may be used for forming the resin phases 32 insofar as the resin phases 32 are impregnated in voids between the ceramic phases 31 as shown in FIG. 3(c). Any application method such as gravure coating, dispenser application, a transfer method, and a spray application may be used. Here, the voids between the ceramic phases 31 include both voids between the ceramic particles and grooves between the ceramic patterns.

The insulating layer 3 has a thickness that is not limited, but is preferred to be 1 to 100 µm. Since the insulating layer 3 has a thickness of equal to or more than 1 µm, the insulating layer 3 ensures sufficient mechanical strength against external forces and sufficient voltage resistance. Since the insulating layer 3 has a thickness of equal to or less than 100 µm, the insulating layer 3 has a sufficiently small thermal resistance. From the aspect of thermal conductivity, it is preferred that the resin phase 32 has a height lower than those of the ceramic phases 31 so as to enlarge the area where the ceramic phases contact the circuit layer.

The circuit layer 4 is a metal layer for circuit wiring. The circuit layer 4 may employ a conductive material with high coefficient of thermal conductivity such as Cu, Cu alloy, Al, and Al alloy.

It is preferred that a method for forming the circuit layer 4 buries a portion (particularly, the ceramic phase 31) of the insulating layer 3 in the circuit layer 4 as shown FIG. 3(d). For example, it is preferred to use vacuum press for metal foil, an aerosol deposition method that uses ceramic particles as raw material, or particle impaction deposition, which is typified by a cold spray method.

In the particle impaction deposition, a base material needs to be softer than a material of film to be formed. In this embodiment, since the resin phases 32 are disposed as a foundation layer, metal particles to form the circuit layer 4 collide with the resin phases 32 so as to form the layer. The resin phases 32 are disposed below the ceramic phases 31. The circuit layer 4 is consequently formed from a height lower than upper ends of the ceramic phases 31. Thus the ceramic phase 31 is formed to be buried in the circuit layer 4. In the case where the circuit layer is formed by the above-described forming method, as shown in FIG. 1(b), a structure where respective portions of the ceramic phases and resin phases are buried in the circuit layer is formed. This increases bonding strength of the bonded portions between the insulating layer and the circuit layer due to an anchor effect.

With the insulating heat conductor according to the embodiment, the metal base material 2 and the circuit layer 4 are bonded with a bonding structure the major portion of which bonds them via the ceramic phases 31 only. This provides high thermal conductivity. Additionally, in the ceramic phases 31, which constitutes the insulating layer 3, this eliminates the need for a plurality of graded composition layers to reduce thermal stress. This ensures the reduced thickness and thermal resistance of the insulating layer 3.

The ceramic phase 31, which constitutes the insulating layer 3, has a portion buried in the metal base material 2 and the circuit layer 4. The bonded portions between the insulating layer 3 and the metal base material 2 and between the insulating layer 3 and the circuit layer 4 have high bonding strength due to an anchor effect.

Further, the insulating layer 3 has a cross-sectional surface that includes the ceramic phases 31, which are formed of a number of the deposited ceramic particles, in a plurality of the independent patterns. Additionally, the resin phases 32 disposed between the ceramic phases 31 promote stress reduction on the insulating layer 3. Thus, in the case where the thermal deformation action occurs due to temperature cycles and the like, thermal stresses on respective ceramic phases 31 are small. The thermal stress is not locally concentrated in the whole insulating layer 3. This reduces crack formation and delamination of the insulating layer 3, thus ensuring high stability to a thermal deformation action.

From the aspect of production cost, this reduces bonding material (such as solder) and a part of the insulating layer member, which are required for the insulating heat conductive structure. This ensures a simplified manufacturing process and material cost reduction.

### Second Embodiment

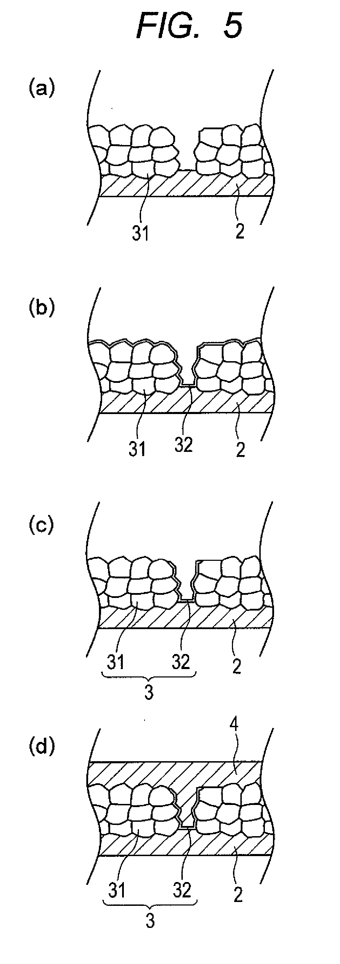

Next, a second embodiment of the present invention will be described in detail below by referring to FIG. 4 and FIG. 5. The second embodiment to be described includes a basic configuration similar to the first embodiment. Accordingly, FIG. 1(b) is referred in FIG. 4 and FIG. 5. Like reference numerals designate corresponding or identical elements throughout FIG. 1(b), FIG. 4, and FIG. 5, and such elements will not be further elaborated here.

A difference between the second embodiment and the first embodiment is a shape of a bonding portion between the insulating layer 3 and the circuit layer 4. As shown in FIG. 4, the resin phases in the insulating layer have small volume. Thus grooves are formed between the ceramic phases of the insulating layer. In the case where the circuit layer 4 is formed on the insulating layer 3 with the groove, the circuit layer 4 forms a structure buried in the groove portion. Thus the bonding portion between the insulating layer and the circuit layer has high bonding strength due to the increased anchor effect.

Next, a method for manufacturing the insulating heat conductive structure according to the second embodiment will be described. First, the method has the same processes as those of the first embodiment until the ceramic phases 31 on the surface of the metal base material 2 as shown in FIG. 5(a) are formed. Then, resin is thinly applied over the whole surfaces of the ceramic phases 31 and the metal base material 2 between the ceramic phases 31 (FIG. 5(b)). At this time, a resin application amount is small compared with that of the first embodiment. Thus the groove is not filled with the resin phase 32. In the subsequent process, the circuit layer 4 is formed in the groove.

Next, the resin phases 32 on the top surfaces of the ceramic phases 31 are removed by, for example, polishing. This completes formation of the insulating layer 3 (FIG. 5(c)).

Then, the circuit layer 4 is formed on the insulating layer 3 (FIG. 5(d)). The circuit layer 4 may be formed by vacuum press for metal foil or particle impaction deposition, similarly to the first embodiment. The circuit layer 4 is bonded on the resin phases 32 with high bonding strength due to the high anchor effect. The circuit layer 4 has high bonding strength and high thermal conductivity with the ceramic phases 31 buried in the circuit layer 4.

### Industrial Applicability

A structure according to the present invention is applicable to a general product that requires an insulating heat conductive structure such as a module of IGBT, MOSFET, JFET, or a diode, and is preferred particularly to a power semiconductor module.

### Reference Signs List

- 1: Insulating Heat Conductor
- 2: Metal Base Material
- 3: Insulating Layer
- 31: Ceramic Phase
- 32: Resin Phase
- 4: Circuit Layer

## Claims

1. An insulating heat conductive structure comprising:
a metal base material;
an insulating layer formed on the metal base material; and
a metal layer formed on the insulating layer, wherein
the insulating layer includes a ceramic layer and a resin phase.

2. The insulating heat conductive structure according to claim 1, wherein
the ceramic phase is formed by particle impaction deposition.

3. The insulating heat conductive structure according to claim 1, wherein
the ceramic phase includes ceramics in a particle form, and
a part of the particles are buried in the metal substrate and the metal layer.

4. The insulating heat conductive structure according to claim 1, wherein
the ceramic phases are formed in a plurality of patterns, the plurality of patterns being separated by a groove, and
the resin layer is formed in the groove.

5. The insulating heat conductive structure according to claim 1, wherein
the ceramic phase is directly coupled to the metal layer outside the groove.

6. The insulating heat conductive structure according to claim 1, wherein
the metal layer is formed by one of particle impaction deposition and a metal press method.

7. The insulating heat conductive structure according to claim 1, wherein
the metal layer has a lowest portion arranged below an uppermost portion of the ceramics layer.

8. A method for manufacturing an insulating heat conductive structure, the method comprising:
forming ceramic phases on a metal base material by particle impaction deposition;
forming resin phases between the ceramic phases; and
forming a metal layer on the ceramic phases and the resin phases.

9. The insulating heat conductive structure according to claim 8, wherein
the ceramic phase includes ceramics in a particle form, and
a part of the particles are buried in the metal substrate and the metal layer.

10. The method for manufacturing an insulating heat conductive structure according to claim 8, wherein
the ceramic phases are formed in a plurality of patterns, the plurality of patterns being separated by a groove,
the resin layer is formed in the groove.

11. The method for manufacturing an insulating heat conductive structure according to claim 10, wherein
the ceramic phases are formed with a mask pattern so as to form the groove in the ceramics.

12. The method for manufacturing an insulating heat conductive structure according to claim 8, further comprising
removing the resin phase on the ceramic phase outside the groove after forming the resin phase and before forming the metal layer.

13. The method for manufacturing an insulating heat conductive structure according to claim 8, wherein
the metal phase is formed by one of particle impaction deposition and a metal press method.

14. The method for manufacturing an insulating heat conductive structure according to claim 8, wherein
the metal layer has a lowest portion arranged below an uppermost portion of the ceramics layer.
